# FASCICULE DE BREVET EUROPEEN

(11) **EP 1 116 424 B1**
(45) Date de publication et mention de la délivrance du brevet: **01.06.2005**
(21) Numéro de dépôt: 00958578.7
(22) Date de dépôt: 21.07.2000
(51) Int. Cl.: H05K 7/20

(54) **ASSEMBLAGE ELECTRONIQUE COMPORTANT UNE SEMELLE FORMANT DRAIN THERMIQUE**
ELEKTRONISCHE BAUGRUPPE MIT EINER WÄRMEPLATTE
ELECTRONIC ASSEMBLY COMPRISING A SOLE PLATE FORMING A HEAT SINK

(30) Priorité: 23.07.1999 FR 9909701
(43) Date de publication de la demande: 18.07.2001
(73) Titulaire: Valeo Electronique et Systèmes de Liaison, 78180 Montigny le Bretonneux (FR)
(72) Inventeur: MARTIN, Gérard-Marie, F-75008 Paris (FR)
(74) Mandataire: de la Bigne, Guillaume Michel Marie
(86) Numéro de dépôt international: PCT/FR2000/002098
(87) Numéro de publication internationale: WO 2001/008459

(56) Documents cités:
- DE-A- 4 335 525
- DE-A- 19 601 649
- US-A- 5 172 301
- US-A- 5 646 826
- US-A- 5 661 902

## Description

La présente invention est relative à un assemblage du type comportant une carte à circuit imprimé et une semelle formant drain thermique, disposés sur une embase formant radiateur.

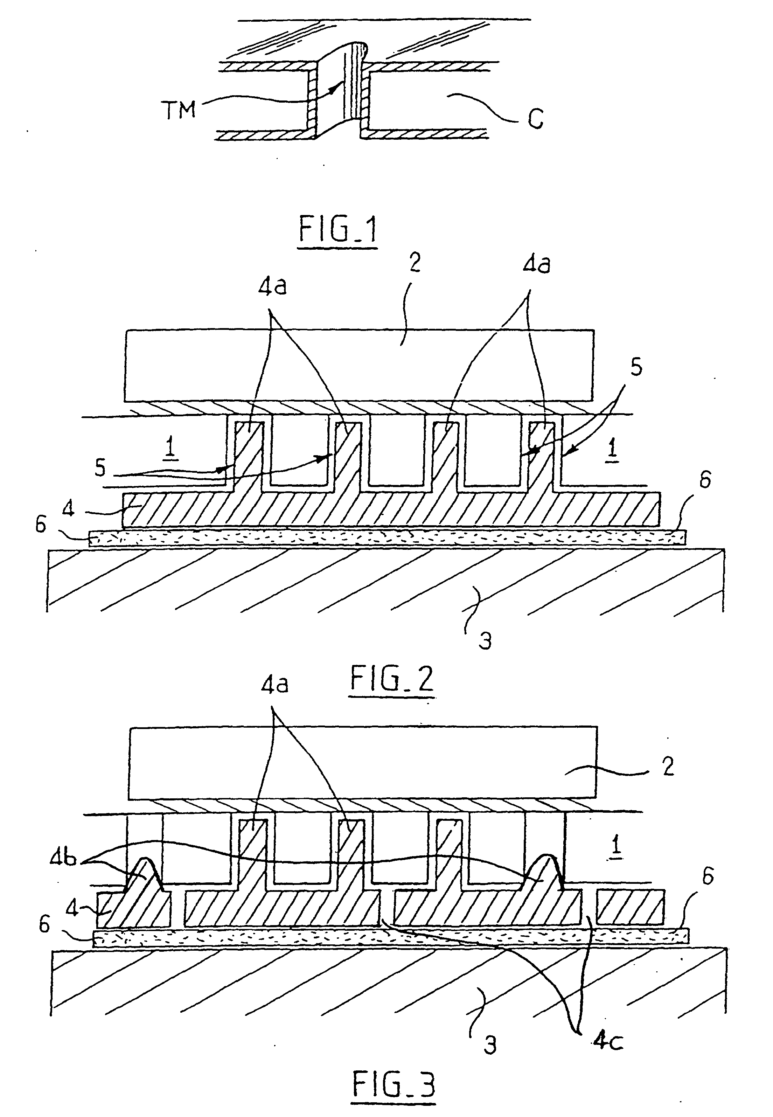

Classiquement, dans un assemblage de ce type, la carte à circuit imprimé est, ainsi qu'illustré sur la figure 1, une carte double face qui présente des trous métallisés TM.

Ces trous métallisés TM constituent ce que l'on appelle des "vias thermiques" qui, en plus de l'interconnexion électrique entre les deux côtés du substrat, permettent un transfert de chaleur entre l'embase et les composants dissipateurs de chaleurs portés par la carte.

Toutefois, le transfert de chaleur que ces trous permettent de réaliser est faible. En effet, bien que la conductivité thermique du cuivre soit environ 1000 fois supérieure à celle des matériaux époxy dans lesquels les substrats des cartes à circuits imprimés sont réalisés, l'épaisseur des couches de cuivre déposées sur les parois des trous qui traversent les substrats étant très faible (de l'ordre de 30 µm), le transfert de chaleur est faible.

Le document US-A-5 646 826 propose dans un assemblage de composant(s) sur une carte à circuit imprimé présentant des vias thermique, d'augmenter la capacité de transfert de chaleur de ces trous en y injectant une matière dont les propriétés de dissipation thermique sont supérieures à celles de la carte à circuit imprimé formant le substrat. Les solutions d'injections de ce type sont généralement coûteuses et nécessitent la mise en oeuvre d'un outillage spécifique et important.

Le document DE-A- 196 01 649 propose, dans un assemblage de composant(s) sur une carte à circuit imprimé, de remplacer une partie de la carte à circuit imprimé par une pièce métallique massive plus conductrice que la carte à circuit imprimé. L'utilisation d'une pièce métallique massive entraînent des problèmes de planéité de l'assemblage et exerce des contraintes latérales importantes sur la carte à circuit imprimé.

Les solutions mises en oeuvre dans l'art antérieur présentent de nombreux inconvénients qu'il s'agit de pallier.

Ainsi, un but de l'invention est de proposer un assemblage à drain thermique qui permette un meilleur transfert de chaleur entre l'embase métallique des boîtiers des composants de puissances portés par la carte à circuit imprimé et l'embase par l'intermédiaire d'un drain thermique qui permet un meilleur refroidissement ou une meilleure dissipation thermique de la carte électronique.

A cet effet, l'invention propose un assemblage porté sur une embase formant radiateur ou apte à être rapporté sur une telle embase, comportant une carte à circuit imprimé qui présente dans son épaisseur une pluralité de trous destinés à assurer un transfert de chaleur entre une face de ladite carte à circuit imprimé qui porte un ou plusieurs composants électroniques entourés chacun d'un boîtier et l'embase formant radiateur, l'assemblage comportant une pluralité de plots qui sont en un matériau qui est conducteur thermique et qui traversent la carte à circuit imprimé sur sensiblement toute son épaisseur en étant reçus dans les trous que celle-ci présente, pour assurer un transfert de chaleur entre une face de la carte à circuit imprimé qui porte un ou plusieurs composants et l'embase, les plots (4a) sont d'une pièce avec une plaque (4) appelée semelle qui les porte, caractérisé en ce que la semelle (4) est interposée entre la carte (1) à circuit imprimé et l'embase.

L'invention est avantageusement complétée par les différentes caractéristiques suivantes, prises seules ou selon toutes leurs combinaisons possibles :
- la semelle est dans un matériau identique à celui d'une embase du fond du boîtier de composant ou dans un matériau de coefficient de dilatation et/ou de conductivité thermique équivalents ;
- l'assemblage comporte un joint thermique ductile par lequel il est en contact avec l'embase ;
- des plots sont directement portés par le boîtier de composant électronique et sont en contact avec l'embase par l'intermédiaire d'un joint ductile thermique ;
- la semelle comporte des moyens complémentaires aptes à assurer son maintien mécanique avec la carte.
- les moyens complémentaires de maintien sont des picots portés par la semelle
- la semelle (4) et les plots (4a) sont brasés sur la carte pour permettre un étalement de la dissipation thermique.
- la semelle présente des trous traversants pour permettre d'évacuer l'air résiduel éventuellement prisonnier dans la brasure

D'autres caractéristiques et avantages de l'invention ressortiront encore de la description qui suit qui est purement illustrative et non limitative et qui doit être lue en regard des dessins annexés sur lesquels :
- la figure 1, déjà analysée, illustre une structure de carte à circuit imprimé présentant des trous (métallisés ou non) conforme à un mode de réalisation connu dans l'état de la technique ;
- la figure 2 est une représentation schématique en coupe d'un assemblage conforme à un mode de réalisation possible de l'invention ;
- la figure 3 est une représentation schématique en coupe d'un assemblage conforme à un mode de réalisation possible pour l'invention intégrant des moyens de maintient entre la semelle et la carte à circuit imprimé ;
- les figures 4a et 4b sont des représentations schématiques en coupe d'un assemblage conforme à un autre mode de réalisation possible pour l'invention.

L'assemblage illustré sur la figure 2 comporte une carte 1 à circuit imprimé sur laquelle sont montés un ou plusieurs boîtiers de composants 2 électroniques à montage de surface. Ces boîtiers de composant présentent en leur fond en regard de la carte à circuit imprimé une embase métallique. L'assemblage comporte également une pièce 3 qui est une embase formant radiateur, qui est destinée à dissiper la chaleur générée par la carte 1 et le ou les composants 2.

Une semelle 4 en un matériau fortement conducteur est interposée entre la carte 1 et l'embase formant radiateur.

Cette semelle 4 présente une pluralité de plots 4a qui s'étendent en saillie par rapport à sa face qui est directement en regard de la carte 1 et qui traversent ladite carte 1 sur sensiblement toute son épaisseur, au niveau d'orifices traversants 5 que celle-ci présente.

Par "plots", on entend ici et dans tout le présent texte des éléments qui sont indépendants de la carte 1 et qui sont en particulier distincts d'une couche métallisée que cette carte 1 pourrait présenter, notamment au niveau de ses orifices traversant 5.

La semelle 4 est de préférence dans un matériau identique à celle de l'embase du fond du boîtier de composant 2 ou dans un matériau dont le coefficient de dilatation thermique et la conductivité thermique sont voisins de ceux de l'embase du fond du boîtier. Ainsi, la somelle sera de préférence en cuivre.

Pour favoriser le contact entre la semelle 4 et l'embase 3, un joint thermique 6 ductile est inséré entre ces deux pièces. Ce joint permet d'augmenter la dissipation thermique.

Le ou les boîtiers de composants CMS 2 sont par exemple soudés par brasure sur la carte 1 et les extrémités des plots 4a. La semelle 4 peut également être soudée par brasure avec la carte 1 à circuit imprimé.

Cette étape de brasure peut être réalisée directement en une étape mais il peut être souhaitable pour des questions de manipulation des pièces lors de la réalisation de l'assemblage de réaliser la brasure en deux étapes. Ainsi, dans un premier temps, on soude par brasure la semelle 4 sur la carte à circuit imprimé 1 puis dans un second temps le ou les boîtiers de composants 2 sur la carte à circuit imprimé 1.

La semelle 4 et les plots 4a sont brasés sur la carte à circuit imprimé pour obtenir une dissipation thermique plus importante. En effet, en augmentant le contact, par l'intermédiaire de la brasure, on optimise le transfert d'énergie vers l'embase 3 et on étale au mieux la dissipation thermique. Mais, on peut également reporter utiliser un procédé de collage pour réaliser ces assemblages

L'embase 3 formant radiateur est par exemple un pièce en aluminium recouverte d'une couche d'isolant électrique.

Avec une telle structure, la quantité de matière conductrice de la chaleur à travers le substrat de la carte 1 est fortement accrue. Le transfert de chaleur est alors augmenté de façon très importante entre la face supérieure de la carte 1 et l'embase 3 formant radiateur.

Les plots 4a sont bien entendu de préférence des éléments pleins, de façon à assurer un transfert thermique aussi important que possible.

Cette solution permet avantageusement de considérer la semelle 4 comme un « composant » à part entière que l'on vient positionner lors de la réalisation de l'assemblage selon l'invention.

Le diamètre des trous TM, métallisés ou non, réalisés à carte à circuit imprimé 1 est comprise entre 0,4 et 1mm en moyenne. Il est alors possible, connaissant la taille des boîtiers de composants de puissance, d'estimer de façon approximative le nombre de plots présents sous chaque boîtier de composant. Le nombre de plots présents sous chaque boîtier de composant varie entre 10 et 20 selon la taille du boîtier de composant. Ce nombre de plots est important et permet effectivement d'améliorer de façon importante la dissipation thermique de la chaleur produite par le composant de puissance.

La figure 3 présente un assemblage selon l'invention comprenant un exemple de moyens complémentaires de maintient de la semelle 4 sur la carte à circuit imprimé 1.

La semelle 4 comporte, en plus des plots 4a, des moyens qui assurent son maintien mécanique par rapport à la carte à circuit imprimé 1. Ces moyens complémentaires sont par exemple des moyens de verrouillage élastiques ("clips") ou des picots s'insérant à force.

La figure 3 présente une semelle 4 comportant des picots 4b, de forme généralement conique, pour permettre une insertion à force des picots 4b dans des trous réalisés dans la carte à circuit imprimé 1, de façon à réaliser un maintient de la carte à circuit imprimé 1 par rapport à la semelle 4 quelque soit la manipulation qui est faite de l'ensemble.

La semelle 4 présente également des trous traversants 4c en certains endroits pour permettre d'évacuer l'air résiduel qui pourrait se trouver emprisonné dans la brasure sous le composant de puissance.

La carte 1, la semelle 4 et l'embase 3 formant radiateur sont ensuite assemblées par pressage à froid et sertissage, ou par toute autre technique (vissage, ressort d'appui) permettant d'assurer le pressage mécanique de l'ensemble. On peut avantageusement réaliser cet assemblage sur une embase structurée qui présenterait deux niveaux, l'un plus en creux pour accueillir la semelle 4, l'autre moins creusé, d'une épaisseur égale à celle de la semelle 4, sur laquelle repose le circuit imprimé et sur lequel s'effectue le sertissage de l'ensemble.

L'assemblage selon l'invention permet un respect des conditions de dilatation des différents éléments les uns par rapport aux et assure une planéité de l'ensemble grâce à la présence d'une surface de référence sur la semelle (4).

En variante, il peut être prévu que un ou des plots thermiques sont directement portés par les composants CMS 2, au lieu d'être portés par une semelle métallique indépendantes.

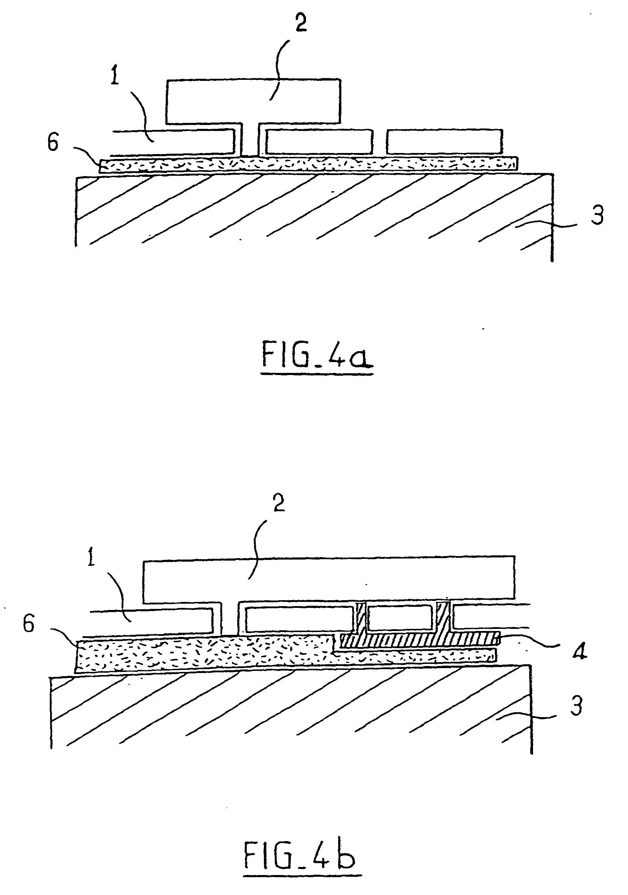

C'est ce qu'illustrent les figures 4a et 4b.

La carte à circuit imprimé 1 est rapportée sur l'embase 3 par l'intermédiaire d'un joint ductile thermique 6 et porte les composants 2 sur sa face opposée au joint 6 et à l'embase 3.

Dans cette configuration, le joint thermique ductile 6 est interposé entre la carte 1 et l'embase 3, un ou des plots portés par les composants 2 étant en contact avec l'embase 3 par l'intermédiaire dudit joint thermique 6.

Il est encore possible d'améliorer la dissipation thermique en combinant l'utilisation de boîtier de composants 2 possédant des plots et d'une semelle 4 présentant des plots 4a comme le montre la figure 4b.

## Revendications

1. Assemblage porté sur une embase formant radiateur ou apte à être rapporté sur une telle embase, comportant une carte (1) à circuit imprimé qui présente dans son épaisseur une pluralité de trous (5) destines à assurer un transfert de chaleur entre une face de ladite carte (1) à circuit imprimé qui porte un ou plusieurs composants électroniques (2) entourés chacun d'un boîtier et l'embase (3) formant radiateur, l'assemblage comportant une pluralité de plots (4a) qui sont en un matériau qui est conducteur thermique et qui traversent la carte (1) à circuit imprimé sur sensiblement toute son épaisseur en étant reçus dans les trous (5) que celle-ci présente, pour assurer un transfert de chaleur entre une face de la carte (1) à circuit imprimé qui porte un ou plusieurs composants (2) et l'embase, les plots (4a) sont d'une pièce avec une plaque (4) appelée semelle qui les porte, **caractérisé en ce que** la semelle (4) est interposée entre la carte (1) à circuit imprimé et l'embase.

2. Assemblage selon la revendication 1, **caractérisé en ce que** la semelle (4) est dans un matériau identique à celui d'une embase du fond du boîtier de composant (2) ou dans un matériau de coefficient de dilatation et/ou de conductivité électrique voisine.

3. Assemblage selon la revendication 1, **caractérisé en ce que** 'il comporte un joint thermique ductile (6) par lequel il est en contact avec l'embase (3).

4. Assemblage selon la revendication 2, **caractérisé en ce que** des plots sont directement portés par le boîtier de composant étectronique (2) et sont en contact avec l'embase (3) par l'intermédiaire d'un joint ductile (6).

5. Assemblage selon la revendication 1, **caractérisé en ce que** la semelle (4) comporte des moyens complémentaires aptes à assurer son maintien mécanique avec la carte (1).

6. Assemblage selon la revendication 5, **caractérisé en ce que** la les moyens complémentaires de maintien sont des picots (4b) portés par la semelle (4) s'insérant à force dans des trous que porte la carte à circuit imprimé (1).

7. Assemblage selon la revendication 1, **caractérisé en ce que** la semelle (4) et les plots (4a) sont brasés sur la carte à circuit imprimé (1) pour permettre un étalement de la dissipation thermique.

8. Assemblage selon la revendication 1 et 7 prises en combinaison, **caractérisé en ce que** la semelle (4) présente des trous traversants (4c) pour permettre d'évacuer l'air résiduel éventuellement prisonnier dans la brasure.

9. Assemblage selon la revendication 2, **caractérisé en ce que** le boîtier de composant (2) est sondé sur la carte (1) à circuit imprimé et les plots (4a).

10. Assemblage selon la revendication 9, **caractérisé en ce que** le boîtier de composant (2) est soudé par brasure sur la carte (1) à circuit imprimé et les plots (4a).

11. Assemblage selon l'une quelconque des revendications précédentes, **caractérisé en ce que** les trous (5) ont un diamètre compris entre 0,4 et 1mm en moyenne.

12. Assemblage selon l'une quelconque des revendications précédentes, **caractérisé en ce que** le boîtier de composant (2) est un boîtier de composant de puissance à montage de surface.

## Patentansprüche

1. Auf einer einen Kühler bildenden Grundplatte angeordnete oder auf eine solche Grundplatte aufsetzbare Anordnung mit einer Leiterplatte (1), welche in ihrer Dicke eine Mehrzahl von Löchern (5) aufweist, welche dafür bestimmt sind, eine Wärmeübertragung zwischen einer ein oder mehrere jeweils von einem Gehäuse umschlossene elektronische Bauteile (2) tragenden Seite der genannten Leiterplatte (1) und der einen Kühler bildenden Grundplatte (3) zu gewährleisten, wobei die Anordnung eine Mehrzahl von Kontakten (4a) aus einem wärmeleitenden Material aufweist, welche weitestgehend die gesamte Dicke der Leiterplatte (1) durchqueren und dabei in die Löcher (5) derselben aufgenommen werden, um eine Wärmeübertragung zwischen einer ein oder mehrere elektronische Bauteile (2) tragenden Seite der Leiterplatte (1) und der Grundplatte zu gewährleisten, wobei die Kontakte (4a) einstückig mit einer sie tragenden, als Sohle bezeichneten Platte (4) ausgebildet sind, **dadurch gekennzeichnet, dass** die Sohle (4) zwischen der Leiterplatte (1) und der Grundplatte angeordnet ist.

2. Anordnung nach Anspruch 1, **dadurch gekennzeichnet, dass** die Sohle (4) aus einem mit dem Material einer Grundplatte des Bodens des Gehäuses eines Bauteils (2) identischen Material oder aus einem Material mit einem benachbarten Ausdehnungskoeffizienten und/oder einer benachbarten elektrischen Leitfähigkeit besteht.

3. Anordnung nach Anspruch 1, **dadurch gekennzeichnet, dass** sie eine dehnbare Thermodichtung (6) aufweist, über welche sie die Grundplatte (3) kontaktiert.

4. Anordnung nach Anspruch 2, **dadurch gekennzeichnet, dass** Kontakte unmittelbar von dem Gehäuse eines elektronischen Bauteils (2) getragen werden und die Grundplatte (3) über eine dehnbare Dichtung (6) kontaktieren.

5. Anordnung nach Anspruch 1, **dadurch gekennzeichnet, dass** die Sohle (4) zusätzliche Mittel aufweist, welche geeignet sind, sie mit der Leiterplatte (1) mechanisch zusammenzuhalten.

6. Anordnung nach Anspruch 5, **dadurch gekennzeichnet, dass** es sich bei den zusätzlichen Festhaltemitteln um Noppen (4b) handelt, welche von der Sohle (4) getragen werden und in Löcher der Leiterplatte (1) hineingetrieben werden.

7. Anordnung nach Anspruch 1, **dadurch gekennzeichnet, dass** die Sohle (4) und die Kontakte (4a) auf der Leiterplatte (1) gelötet werden, um eine Verteilung der Wärmeabführung zu ermöglichen.

8. Anordnung nach Anspruch 1 in Verbindung mit Anspruch 7, **dadurch gekennzeichnet, dass** die Sohle (4) Durchgangslöcher (4c) aufweist, um die eventuell in der Lötmasse eingeschlossene Restluft abzuführen.

9. Anordnung nach Anspruch 2, **dadurch gekennzeichnet, dass** das Gehäuse eines Bauteils (2) auf der Leiterplatte (1) und an den Kontakten (4a) geschweißt ist.

10. Anordnung nach Anspruch 9, **dadurch gekennzeichnet, dass** das Gehäuse eines Bauteils (2) auf der Leiterplatte (1) und auf den Kontakten (4a) gelötet ist.

11. Anordnung nach einem der vorhergehenden Ansprüche, **dadurch gekennzeichnet, dass** die Löcher (5) einen Durchmesser haben, welcher durchschnittlich zwischen 0,4 und 1 mm liegt.

12. Anordnung nach einem der vorhergehenden Ansprüche, **dadurch gekennzeichnet, dass** das Gehäuse eines Bauteils (2) ein Gehäuse für ein oberflächenmontiertes Leistungsbauteil ist.

## Claims

1. Assembly supported on a base forming a radiator or capable of being mounted on such a base, comprising a printed circuit card (1) which has in its thickness a plurality of holes (5) intended to transfer heat between one face of the said printed circuit card (1), which supports one or more electronic components (2) each enclosed by a box, and the base (3) forming a radiator, the assembly having a plurality of pads (4a) which are made of a thermally conductive material and pass through the printed circuit card (1) over substantially its whole thickness while being housed by the holes (5) therein, in order to transfer heat between one face of the printed circuit card (1), which supports one or more components (2), and the base, the pads (4a) are integral with a plate (4), referred to as the sole plate, which supports them, **characterized in that** the sole plate (4) is interposed between the printed circuit card (1) and the base.

2. Assembly according to claim 1, **characterized in that** the sole plate (4) is made of the same material as a base of the bottom of the box of components (2) or of a material with similar coefficient of expansion and/or electrical conductivity.

3. Assembly according to claim 1, **characterized in that** it has ductile thermal joint (6) through which it is in contact with the base (3).

4. Assembly according to claim 2, **characterized in that** pads are directly supported by the box of electronic components (2) and are in contact with the base (3) through a ductile joint (6).

5. Assembly according to claim 1, **characterized in that** the sole plate (4) has complementary means capable of mechanically holding it to the card (1).

6. Assembly according to claim 5, **characterized in that** complementary holding means are spikes (4b) which are supported by the sole plate (4) and are force-fitted into holes in the printed circuit card (1).

7. Assembly according to claim 1, **characterized in that** the sole plate (4) and the pads (4a) are soldered to the printed circuit card (1) in order to spread the thermal dissipation.

8. Assembly according to claims 1 and 7 taken in combination, **characterized in that** the sole plate (4) has through-holes (4c) for discharging the residual air possibly trapped in the solder.

9. Assembly according to claim 2, **characterized in that** the box of components (2) is welded to the printed circuit card (1) and to the pads (4a).

10. Assembly according to claim 9, **characterized in that** the box of components (2) is welded by soldering to the printed circuit card (1) and to the pads (4a).

11. Assembly according to any of the preceding claims, **characterized in that** the holes (5) have a diameter between 0,4 and 1 mm on average.

12. Assembly according to any one the preceding claims, **characterized in that** the box of components (2) is a surface-mount power box of components.
